# EUROPEAN PATENT APPLICATION

(11) **EP 2 508 646 A1**
(43) Date of publication of application: **10.10.2012**
(21) Application number: 11161176.0
(22) Date of filing: 05.04.2011
(51) Int. Cl.: C23C 14/56

(54) **A process for multi-layer continuous roll-to-roll coating**

(71) Applicant: Bayer Material Science AG, 51368 Leverkusen (DE); Bayer (South East Asia) Pte Ltd., Singapore 049514 (SG)
(72) Inventor: Yan, Min (Martin), 537885 Singapore (SG); Schmidt, Axel, 239191 Singapore (SG); Reichert, Peter, 41541 Dormagen (DE)
(74) Representative: Colling-Hendelkens, Miriam

(57) **Abstract**

The invention relates to a process for the continuous production of a flexible substrate, preferably a plastics film containing a multi-layer coating in a roll-to-roll coating process, in which at least one vacuum coating process and at least one wet coating process are combined together, and to a device for use in such a process.

## Description

The invention relates to a process for the continuous production of a flexible substrate, preferably a plastics film containing a multi-layer coating in a roll-to-roll coating process, in which at least one vacuum coating process and at least one wet coating process are combined together, and to a device for use in such a process.

Particularly in coated films having multi-layer coatings containing both inorganic and organic layers, the problem generally exists that such layers have to be applied using very different coating processes. Particularly in the case of coatings which are intended to reduce significantly the oxygen and/or water permeability of the plastics film ― so-called barrier coatings ― inorganic and organic layers often alternate in order to improve the barrier effect of the overall coating. The inorganic layers are generally tightly packed oxide or nitride layers which are applied by vacuum deposition processes. To compensate for defects in these layers and a resulting impairment of the barrier effect, organic layers are preferably applied between several inorganic layers for decoupling defects, possibly also smoothing surface, and reducing defect density in the subsequent inorganic layer. Acrylates are preferably used for these organic layers. However, organic coating materials of this type are preferably applied from solution by wet coating processes in atmosphere pressure, so it has often been necessary up to now to resort to batch processes for coating alternately with these inorganic and organic layers owing to the significantly different pressure conditions. However, for economic reasons alone these batch processes are disadvantageous for the industrial-scale production of such products.

Furthermore, there have been attempts in the past to carry out coating with inorganic and organic layers in continuous processes using flash evaporation to deposit the organic layers instead of wet coating processes (see e.g. US 5,260,095 or US 6,358,570). However, the application of acrylate monomers by flash evaporation in particular entails the disadvantage that the acrylates are deposited not only on the substrate to be coated, but also on the insides and components of the coating equipment and, after a certain operating period, can for example cause problems with the operation of the pumps, transport rolls, valves etc. The production operation then has to be interrupted for time-consuming cleaning.

A direct combination of vacuum and wet coating processes for a continuous roll to roll process for the alternate application of inorganic and organic layers has not hitherto been described.

WO 2010/014058 A1 describes a process for the production of electronic devices with thin coated films, and mentions *inter alia* the application of multi-layer barrier coatings. However, WO 2010/014058 A1 on the one hand fails to disclose how in particular the alternating construction of the inorganic oxide layer and the organic smoothing layer is to be achieved in the continuous process described, and on the other hand it is not possible with the process described in WO 2010/014058 A1 to achieve a coating over the entire surface of the plastics substrate, since contact with the coated side of the plastics substrate cannot be avoided in the complex roll guide system within the collecting chamber. WO 2010/014058 A1 avoids or reduces contact with the applied coating by means of recesses in the transport rolls, but a coating of the entire surface is not possible without contact with these rolls and thus the risk of damage. In addition, the width of the substrate to be coated is considerably restricted by only lateral contact with the transport rolls. Since in particular the inorganic layers of multi-layer barrier coatings, but particularly also of conductive coatings, can be damaged very easily on contact with guide rolls and resulting friction effects, the barrier effect or conductivity of such coatings can be significantly impaired here. Moreover, the process described in WO 2010/014058 A1 requires a collecting chamber upstream of the vacuum coating chamber, which is operated at a pressure between atmospheric pressure and the pressure in the vacuum coating chamber, which according to WO 2010/014058 A1 necessarily requires the use of two gas gates to bridge the pressure difference from atmospheric pressure to the pressure in the vacuum coating chamber. Such an arrangement requires not only complex control technology and the costly use of several gas gates between the different pressure areas but also requires the repeated transport of the coated substrate through these gas gates, in which for reasons of the efficient web handling, direct contact of coated surface of plastic substrate with transport rollers, and thus friction effects, cannot be avoided altogether. The smallest possible number of such gas gates is therefore desirable during the coating process.

Accordingly, a need still existed for a process for the continuous production of a flexible substrate, preferably a plastics film containing a multi-layer coating in a roll-to-roll coating process, as well as a device for use in such a process, by means of which the disadvantages of the processes known hitherto can be avoided.

The object on which the present invention was based therefore consisted in finding such a process for the continuous production of a flexible substrate, preferably a plastics film containing a multi-layer coating in a roll-to-roll coating process, in which at least one vacuum coating process and at least one wet coating process can be combined with one another by simple means. In addition, a coating of the entire surface should be possible with this process even on broad flexible substrates and the risk of damage to the coating by contact with transport rolls or friction effects should be as low as possible. A further object consisted in finding a device for use in such a process.

This object can be achieved by a process for the continuous production of a flexible substrate, preferably a plastics film containing a multi-layer coating in a roll-to-roll coating process, in which at least one vacuum coating chamber and at least one wet coating area are connected together by at least one gas gate, preferably in each case only one gas gate, and the transport of the flexible substrate outside the vacuum coating chamber takes place without direct contact of the coated side of the plastics film with the transport and/or guide rolls.

The present invention therefore provides a process for the continuous production of a flexible substrate, preferably a plastics film containing a multi-layer coating in a roll-to-roll coating process, wherein the multi-layer coating has at least one inorganic and at least one organic layer, characterised in that
(a) at least one inorganic layer of the multi-layer coating is applied in at least one vacuum coating chamber at a pressure of less than 10⁻² bar with a vacuum coating process, and
(b) at least one organic layer of the multi-layer coating is applied at atmospheric pressure in a wet coating process,
wherein at least one gas gate is located between a vacuum coating chamber and an area for the wet coating process and
the transport of the coated flexible substrate, preferably the coated plastics film outside the vacuum coating chamber takes place in such a way that the side of the flexible substrate having the coating has no direct contact with the transport and/or guide rolls.

In preferred embodiments of the process according to the invention, only one gas gate in each case is located between a vacuum coating chamber and an area for the wet coating process.

In these preferred embodiments of the process according to the invention, it is in particular unnecessary to use two or more gas gates between the vacuum coating chamber with a pressure of less than 10⁻² bar and the area for the wet coating process at atmospheric pressure. As a result, friction effects which can result from contact of the coated surface of the plastics film with the transport rollers are significantly reduced compared with the use of several gas gates.

Transport of the coated flexible substrate, preferably the coated plastics film outside the vacuum coating chamber in such a way that the side of the felxible substrate having the coating has no direct contact with the transport and/or guide rolls preferably takes place by transporting the coated flexible substrate using conventional transport and/or guide rolls, such as e.g. metal transport and/or guide rolls, only in such a way that the uncoated side of the flexible substrate comes into contact with these rolls. In cases in which transport takes place with the coated side of the flexible substrate facing the transport and/or guide rolls, so-called air turn rollers are used in the process according to the invention, by means of which the coated flexible substrate is transported in a completely contactless manner over an air film, separated from the surface of the rolls. Thus, contact of the coated side of the flexible substrate with the transport and/or guide rolls and resulting damage to the coating can be completely avoided. In addition, this procedure offers the possibility of producing even fully coated substrates without the risk of damaging the coating by the transport and/or guide rolls and the width of the film web used as substrate for the coating is not restricted unnecessarily by the transport and/or guide rolls.

The process according to the invention is for example suitable for the production of barrier coatings, i.e. coatings to reduce the oxygen and/or water permeability of the plastics film, transparent conductive coatings or anti-reflection coatings. Preferably the process according to the invention is suitable for the production of barrier coatings. The process according to the invention is preferably suitable for those coatings in which inorganic and organic layers alternate. The process according to the invention is particularly preferably suitable for the production of barrier coatings with alternate inorganic and organic layers.

The inorganic layers are preferably particularly thin layers. Particularly preferably, the inorganic layers each have a layer thickness of 10 to 800 nm, preferably of 20 to 400 nm, particularly preferably of 50 to 200 nm.

The organic layers preferably each have a layer thickness of 5 nm to 50 µm, preferably of 10 nm to 25 µm, and particularly preferably 20 nm to 20 µm, these figures relating to the dry film thickness.

The inorganic layer is preferably one containing at least one oxide, nitride, carbide, boride, fluoride or mixtures of these.

The inorganic layer for barrier coatings is preferably one containing at least one oxide, nitride, carbide, boride or mixtures of these. In addition, these coatings may optionally also contain one or more elements from groups IIA, IIIA, IVA, VA, IVA, VIIA, IB or IIB of the periodic table, metals from groups IIIB, IVB or VB of the periodic table or rare earth metals. Particularly preferred are oxides, nitrides, carbides or mixed oxides, oxycarbides, oxynitrides or oxycarbonitrides. Silicon oxides, silicon nitrides, silicon oxynitrides, silicon oxycarbides, metal oxides, mixed oxides of metals, metal nitrides, metal oxynitrides, metal oxycarbonitrides or mixtures of these are particularly preferred. The inorganic layer most particularly preferably contains silicon oxide, aluminium oxide, zinc-tin oxide, silicon nitride, silicon oxycarbide, silicon oxynitride or aluminium oxycarbonitride. In preferred embodiments, the inorganic layer contains silicon oxide, aluminium oxide, zinc-tin oxide or silicon nitride.

The inorganic layer for transparent conductive coatings is preferably one containing at least one selected from the group of indium tin oxide (ITO), antimony doped tin oxide (ATO) or aluminium doped zinc oxide (AZO).

The inorganic layer for anti-reflection coatings is preferably one containing at least one oxide or fluoride having a low, medium or high refractive index n. Such materials having a low refractive index are such materials for which n is smaller than 1.5, such materials having a medium refractive index are such materials for which n is from 1.5 to 2 and such materials having a high refractive index are such materials for which n is more than 2. Materials having a low refractive index are for example SiO₂ or MgF₂, materials having a medium refractive index are for example CeF₃ or Al₂O₃, materials having a high refractive index are for example ZrO₂ or TiO₂. In preferred embodiments the inorganic layer for anti-reflection coatings can comprise more than one inorganic layer wherein these different layers have different refractive indices. Particularly preferred are embodiments with more than one inorganic layer wherein the different inorganic layers are selected from the different groups of materials having low, medium or high refractive indices. Such multilayered inorganic layers can preferably be coated on the substrate in one vacuum coating process by using different vacuum modules for the coating of the different materials.

The vacuum deposition processes known to the person skilled in the art may be considered as suitable vacuum coating processes for the inorganic layer(s). The vacuum coating process is preferably a chemical or physical vapour deposition, a reactive sputtering process or a reactive evaporation process. As processes for chemical vapour deposition, for example plasma-enhanced chemical vapour deposition (PECVD), radio frequency plasma-enhanced chemical vapour deposition (RFPECVD), expanding thermal-plasma chemical vapour deposition (ETPCVD), electron-cyclotron-resonance plasma-enhanced chemical vapour deposition (ECRPECVD), micro wave plasma-enhanced chemical vapour deposition (MWPECVD) or inductively coupled plasma-enhanced chemical vapour deposition (ICPECVD), preferably plasma-enhanced chemical vapour deposition (PECVD), are suitable. As processes for reactive sputtering, DC magnetron sputtering, pulsed DC magnetron sputtering, AC magnetron sputtering or ion beam sputtering are preferably suitable. As processes for reactive evaporation processes thermal or electron-beam evaporation are preferably suitable.

For the chemical vapour deposition process, particularly the plasma-enhanced chemical vapour deposition process, suitable precursors are used for the production of the desired inorganic material, optionally in combination with oxygen or nitrogen. These precursors are known to the person skilled in the art. Non limited examples for the precursors include silane (SiH₄) and ammonia (NH₃) for forming Si₃N₄, tetraethyl-orthosilicate (TEOS) (Si(OC₂H₅)₄) or hexamethyldisiloxane (HMDSO) (O[Si(CH₃)₃]₂) for forming SiO₂, dimethylzinc (Zn(CH₃)₂) or diethylzinc ((C₂H₅)₂Zn) for forming ZnO, dimeric form of triethylaluminium (C₁₂H₃₀Al₂) for forming Al₂O₃, SnCl₄ and H₂O for forming SnO₂.

In the process according to the invention, the working pressure in the vacuum coating chamber is less than 10⁻² bar, preferably 10⁻³ to 10⁻⁷ bar, particularly preferably 10⁻³ to 10⁻⁶ bar. In preferred embodiments the vacuum chamber is evacuated to a base pressure of less than 10⁻⁵ bar, preferably to a base pressure of 10⁻⁶ to 10⁻¹⁰ bar, before starting the vacuum coating process. Such a previous evacuation to a lower base pressure can be advantageous, e.g. for cleaning the vacuum chamber before the vacuum coating process.

For the wet coating process, all the wet coating processes known to the person skilled in the art which are suitable for the continuous coating of flexible substrates are suitable in principle. For example, the wet coating process can be a spray process, casting process, knife-coating process, printing process, roller coating or other continuous wet coating process. Casting processes, for example using slot dies, roller coating or printing processes such as gravure printing or flexo printing, are preferred.

The wet coating process can be carried out in an area which is completely open to ambient or confined in an enclosure. It is preferred to carry out the wet coating process in an enclosure. Carrying out the wet coating process in an enclosure is advantageous, since no solvent vapour can go into ambient. In preferred embodiments the solvent vapour can be collected and recycled. It also may be preferred to carry out the wet coating process under inert gas, such as nitrogen, or dry air, in particular to provide a low oxygen or low humidity level environment. The latter can be in particular advantageous in case the coating material is oxygen sensitive or moisture sensitive. It may also be preferred to carry out the wet coating process under clean-room conditions, in particular low particle density conditions. The latter can be in particular advantageous for the quality of the coating.

Following the wet coating process, drying of the layer applied by wet coating preferably takes place. This drying may take place at room temperature or at an elevated temperature, i.e. thermally. The drying preferably takes place thermally. The solvent contained is completely or partly removed during this process.

Following the wet coating process and possible drying, the layer applied by wet coating is preferably cured. The curing can take place thermally or by irradiation. In preferred embodiments, the curing takes place in the form of radiation curing. Suitable radiation sources are, for example, UV radiators or electron beams. The radiation curing preferably takes place using UV radiation. In the case of thermal curing, the drying and curing can optionally also take place in the same process step. This can take place for example by IR radiation or passing through a drying oven or a drying line or drying unit.

Both the drying and the curing can take place completely or partially. A drying and/or curing of the layer applied by wet coating is particularly preferred when the coating with the organic layer is followed by further coating steps, i.e. a further inorganic layer is to be applied on to the organic coating immediately afterwards. In addition, a drying and/or curing of the layer applied by wet coating may also be preferred if the coated substrate is to be wound immediately into a roll of film. However, there is also the possibility of further coating or subsequent winding even without previous drying and/or curing, or with previous partial drying and/or partial curing, for example by applying a release film. The application of a release film can also be advantageous and preferred even in the case of complete previous drying and/or curing, in order to protect the coating of the flexible substrate from damage.

It may be preferred to carry out the drying and/or curing in a low oxygen or low humidity level environment and/or under clean-room conditions as well as the wet coating process.

The coating composition for the organic layer preferably contains those organic compounds which can be physically dried and/or polymerised and/or optionally also transversely crosslinked by subsequent curing, i.e. can be converted into a higher molecular weight state by curing. For this purpose, all polymerisable monomers as well as prepolymers or polymers capable of further crosslinking or mixtures of these are suitable. The polymerisation in this case can take place by free radicals, cationically, anionically, by polycondensation or by polyaddition. The coating composition additionally contains ― where necessary to initiate the corresponding polymerisation ― suitable polymerisation initiators.

The coating composition for the organic layer preferably contains ethylenically unsaturated compounds. These can be for example ethylenically unsaturated monomers or polymers and mixtures of these.

The coating composition for the organic layer preferably contains at least one compound selected from acrylates, methacrylates, vinyl aromatics, vinyl esters, vinyl ethers, mono- or polyunsaturated alkenes and ethylenically unsaturated nitriles. Most particularly preferably, the coating composition for the organic layer contains one or more acrylates or methacrylates.

Examples of the preferred compounds listed above are, for example, vinyl laurate, vinyl stearate, vinyl propionate and vinyl acetate, styrene, vinyl toluene, α-butyl styrene, 4-n-butyl styrene, 4-n-decyl styrene, acrylonitrile, methacrylonitrile, vinyl methyl ether, vinyl isobutyl ether, vinyl hexyl ether, vinyl octyl ether, butadiene, isoprene, ethylene, propylene and isobutylene, and of the acrylates or methacrylates alkoxylated or non-alkoxylated mono-, di-, tri-, tetra-, penta- or hexaacrylates.

Suitable as these acrylates and methacrylates are, for example, methyl acrylate, ethyl acrylate, n-butyl acrylate, isobutyl acrylate, t-butyl acrylate, 2-ethylhexyl acrylate, isodecyl acrylate, n-lauryl acrylate, C₁₂-C₁₅ alkyl acrylates, n-stearyl acrylate, n-butoxyethyl acrylate, butoxydiethylene glycol acrylate, methoxytriethylene glycol acrylate, cyclohexyl acrylate, tetrahydrofurfuryl acrylate, benzyl acrylate, 2-phenoxyethyl acrylate, isobornyl acrylate, 2-hydroxypropyl acrylate, 2-hydroxyethyl acrylate, 2-hydroxybutyl acrylate, methanediol diacrylate, glycerol diacrylate, neopentyl glycol diacrylate, 2-butyl-2-ethyl-1,3-propanediol diacrylate, trimethylolpropane diacrylate, pentaerythritol triacrylate, glycerol triacrylate, 1,2,4-butanetriol triacrylate, trimethylolpropane triacrylate, tricyclodecanedimethanol diacrylate, ditrimethylolpropane tetraacrylate, pentaerythritol tetraacrylate, dipentaerythritol tetraacrylate, dipentaerythritol pentaacrylate, dipentaerythritol hexaacrylate and the corresponding methacrylates. The alkoxylated, preferably ethoxylated, acrylates and methacrylates mentioned above are also suitable as acrylates and methacrylates.

In the event that the coating composition for the organic layer is radiation-curing, this additionally contains at least one suitable photoinitiator. These suitable photoinitiators (UV-driven initiators) preferably possess high photochemical reactivity and an absorption band in the near UV range (>300 nm and particularly preferably >350 nm).

Suitable photoinitiators are preferably those selected from the group of acyl phosphine oxide derivatives, α-aminoalkylphenone derivatives, hydroxyalkylphenones, benzophenones, benzil ketals, methylbenzoyl formate and phenyl acetophenones.

Examples of these photoinitiators are benzophenone, bis(2,4,6-trimethylbenzoyl)phenyl phosphine oxide (Irgacure® 819 from Ciba Speciality Chemicals), 1-hydroxycyclohexylphenyl ketone (Irgacure® 184 from Ciba Speciality Chemicals), 2-benzyl-2-(dimethylamino)-1-(4-morpholinophenyl)-1-butanone (Irgacure® 369 from Ciba Speciality Chemicals), 2-methyl-1-[4-(methylthio)phenyl]-2-morpholino-1-propanone (Irgacure® 907 from Ciba Speciality Chemicals), (1-hydroxycyclohexyl)phenylmethanone (Irgacure® 1800 from Ciba Speciality Chemicals), 2-hydroxy-2-methyl-1-phenyl-1-propanone (Irgacure® 1700 from Ciba Speciality Chemicals), bis(2,6-dimethylbenzoyl)(2,4,4-trimethylpentyl)phosphine oxide, bis(2,6-dimethoxybenzoyl)(2,4,4-trimethylpentyl)phosphine oxide, (2,4,6-trimethylbenzoyl)diphenylphosphine oxide (Lucirin® TPO Solid from BASF AG), 2,4,6-trimethylbenzoylethoxyphenylphosphine oxide (Lucirin® TPO-L from BASF AG), benzoylphosphonic acid bis(2,6-dimethylphenyl) ester (Lucirin® 8728 from BASF AG) and 2-hydroxy-2-methyl-1-phenyl-1-propanone (Darocur® 4265 from Ciba Speciality Chemicals).

Mixtures of these photoinitiators with one another are also suitable.

Such organic layers are suitable for barrier coatings, transparent conductive coatings or anti-reflection coatings.

Such organic layers can be advantageous because of smoothing surface the surface of the substrate or of the previously applied inorganic layer. In particular for barrier coatings such organic layers are preferably applied between several inorganic layers for decoupling defects and/or for reducing defect density in the subsequent inorganic layer.

Additionally or as an alternative for the organic layer, in particular for transparent conductive coatings, a coating composition preferably containing conductive polymers, such as polythiophenes, polyanilines or polypyrrols can be used. In particular preferred is a coating composition comprising at least one optionally substituted polythiophene.

In preferred embodiments of the present invention, at least one optionally substituted polythiophene is one having repeat units of the general formula (IV), 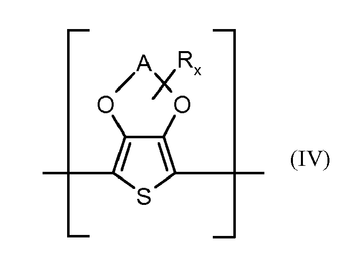 where
- A: stands for an optionally substituted C₁-C₅ alkylene residue,
- R: stands for a linear or branched, optionally substituted C₁-C₁₈ alkyl residue, an optionally substituted C₅-C₁₂ cycloalkyl residue, an optionally substituted C₆-C₁₄ aryl residue, an optionally substituted C₇-C₁₈ aralkyl residue, an optionally substituted C₁-C₄ hydroxyalkyl residue or a hydroxyl residue,
- x: stands for an integer from 0 to 8 and
for the case in which more than one residues R are bonded to A, these may be identical or different.

The general formula (IV) is to be understood in the context of the invention such that x substituents R may be bonded to the alkyl residue A.

Particularly preferred are polythiophenes having repeat units of the general formula (IV) in which A stands for an optionally substituted C₂-C₃ alkylene residue and x stands fur 0 or 1. Poly(3,4-ethylenedioxythiophene), which may optionally be substituted, is more particularly preferred as a conductive polymer. Most preferred as a conductive polymer is unsubstituted poly(3,4-ethylene-dioxythiophene).

In respect of the conductive polymers, in particular polythiophenes, the prefix poly- is to be understood in the context of the invention such that the polymer or polythiophene contains more than one identical or different repeat unit. The polythiophenes contain in total n repeat units of the general formula (IV), where n is an integer from 2 to 2000, preferably from 2 to 100. The repeat units of the general formula (IV) within a polythiophene may respectively be identical or different. Polythiophenes having respectively identical repeat units of the general formula (IV) are preferred.

Preferably, the polythiophenes respectively have H on the end groups.

As further optional substituents of the residues A and/or the residues R, in the context of the present invention many organic groups may be envisaged, for example alkyl, cycloalkyl, aryl, aralkyl, alkoxy, halogen, ether, thioether, disulfide, sulfoxide, sulfone, sulfonate, amino, aldehyde, keto, carboxylic acid ester, carboxylic acid, carbonate, carboxylate, cyano, alkylsilane and alkoxysilane, and carboxylamide groups.

The polythiophenes may be neutral or cationic. In preferred embodiments, they are cationic, "cationic" referring only to the charges which lie on the polythiophene main chain. Depending on the substituent on the residues R, the polythiophenes may carry positive and negative charges in the structural unit, the positive charges lying on the polythiophene main chain and the negative charges optionally lying on the residues R substituted by sulfonate or carboxylate groups. The positive charges of the polythiophene main chain may be partly or fully saturated by the optionally provided anionic groups on the residues R. Considered overall, the polythiophenes may in these cases be cationic, neutral or even anionic. Nevertheless, in the context of the invention they are all considered as cationic polythiophenes since the positive charges on the polythiophene main chain are most important. The positive charges are not represented in the formulae, since their precise number and position cannot be readily established. The number of positive charges is however at least 1 and at most n, where n is the total number of all the repeat units (identical or different) within the polythiophene.

In order to compensate for the positive charge, unless this has already been done by the optionally sulfonate- or carboxylate-substituted and therefore negatively charged residues R, the cationic polythiophenes require anions as counterions.

The counterions may be monomeric or polymeric anions, the latter also being referred to below as polyanions.

Polymeric anions are preferred over monomeric anions, since they contribute to the film formation. Polymeric anions may in this case be for example anions of polymeric carboxylic acids, such as polyacrylic acids, polymethacrylic acids or polymaleic acids, or polymeric sulfonic acids such as polystyrene sulfonic acids and polyvinyl sulfonic acids. These polycarboxylic and -sulfonic acids may also be copolymers of vinylcarboxylic and vinylsulfonic acids with other polymerisable monomers, such as acrylic acid esters and styrene. An anion of a polymeric carboxylic or sulfonic acid is preferred as a polymeric anion. The anion of polystyrene sulfonic acid (PSS) is particularly preferred as a polymeric anion.

The molecular weight of the polyacids providing the polyanions is preferably from 1000 to 2,000,000, particularly preferably from 2000 to 500,000. The polyanions or their alkali salts are commercially available, for example polystyrene sulfonic acids and polyacrylic acids.

The anions of p-toluene sulfonic acid, methane sulfonic acid or camphor sulfonic acid are preferred as monomeric anions.

Such coating compositions are well known to a skilled person in the art. Such organic layers comprising conductive polymers can be advantageous to further improve the flexibility of the inorganic transparent conductive layer(s) and to keep the conductive properties of such inorganic transparent conductive layer(s) even if cracks are formed in these inorganic layers.

Suitable as solvents for the organic coating compositions are, for example, one or more organic solvents, optionally in a mixture with water. One or more organic solvents are preferred. These organic solvents can be selected for example from the group containing aromatic solvents, such as e.g. xylene or toluene, ketones, such as e.g. acetone, 2-butanone, methyl isobutyl ketone, diacetone alcohol, alcohols, such as e.g. methanol, ethanol, i-propanol, 2-methoxypropyl alcohol, ethers, such as e.g. 1,4-dioxane, ethylene glycol n-propyl ether, or esters, such as e.g. ethyl acetate, butyl acetate, 1-methoxy-2-propyl acetate or mixtures containing these solvents. Particularly preferred are i-propanol, ethyl acetate, butyl acetate, 2-methoxypropyl alcohol, xylene or toluene.

In the process according to the invention the vacuum coating process or the wet coating process can be performed as the first coating process. In preferred embodiments of the process according to the invention the vacuum coating process is performed as the first coating process at least followed by a subsequent wet coating process. In alternative preferred embodiments of the process according to the invention the wet coating process is performed as the first coating process at least followed by a subsequent vacuum coating process.

For the application of transparent conductive coatings and anti-reflection coatings it is preferred that first an organic layer is applied to the flexible substrate using a wet coating process at least followed by a subsequent vacuum coating process. For the application of barrier coatings it can be preferred that first an organic layer is applied to the flexible substrate using a wet coating process at least followed by a subsequent vacuum coating process or that first an inorganic layer is applied to the flexible substrate using a vacuum coating process at least followed by a subsequent wet coating process. For the application of barrier coatings it is particularly preferred that first an inorganic layer is applied to the flexible substrate using a vacuum coating process at least followed by a subsequent wet coating process.

As a suitable flexible substrate for use in the process according to the invention, any flexible substrate, such as a plastics film, metal film, thin glass substrate or sol-gel substrate, is suitable. A preferred flexible substrate for use in the process according to the invention is a plastic film, particularly preferred a thermoplastic film is suitable. According to the invention, those films containing at least one layer containing at least one thermoplastic are suitable as thermoplastic films. A thermoplastic film of this type can be a single- or multi-layer thermoplastic film. In the case of a multi-layer thermoplastic film as substrate, this can be a thermoplastic film produced by means of coextrusion, extrusion lamination or lamination, preferably produced by means of coextrusion. The plastics film preferably has a thickness of 10 µm to 1000 µm, particularly preferably 20 to 500 µm, most particularly preferably 30 to 300 µm.

Suitable as thermoplastics for the plastics layers are, independently of one another, thermoplastics selected from polymers of ethylenically unsaturated monomers and/or polycondensates of bifunctional reactive compounds. Transparent thermoplastics are particularly preferred.

Particularly suitable thermoplastics are polycarbonates or copolycarbonates based on diphenols, poly- or copolyacrylates and poly- or copolymethacrylates such as, for example and preferably, polymethyl methacrylate, polymers or copolymers with styrene such as, for example and preferably, transparent polystyrene or polystyrene-acrylonitrile (SAN), transparent thermoplastic polyurethanes, as well as polyolefins such as, for example and preferably, transparent polypropylene types or polyolefins based on cyclic olefins (e.g. TOPAS^{®}, Hoechst), poly- or copolycondensates of terephthalic acid or naphthalene dicarboxylic acid such as, for example and preferably, poly- or copolyethylene terephthalate (PET or CoPET), glycol-modified PET (PETG) or poly- or copolybutylene terephthalate (PBT or CoPBT), poly- or copolyethylene naphthalate (PEN or CoPEN) or mixtures of the aforementioned.

Particularly preferred are those thermoplastics having high transparency and a low haze value, since these are particularly suitable for optical or optoelectronic applications, such as e.g. in display applications. These thermoplastics are particularly preferably polycarbonates or copolycarbonates based on diphenols or poly- or copolycondensates of terephthalic acid such as, for example and preferably, poly- or copolyethylene terephthalate (PET or CoPET), glycol-modified PET (PETG) or poly- or copolybutylene terephthalate (PBT or CoPBT), poly- or copolyethylene naphthalate (PEN or CoPEN) or mixtures of the aforementioned.

Suitable polycarbonates or copolycarbonates are, in particular, aromatic polycarbonates or copolycarbonates. The polycarbonates or copolycarbonates can be linear or branched.

The preparation of these polycarbonates or copolycarbonates can be carried out in a known manner from diphenols, carbonic acid derivatives, optionally chain terminators and optionally branching agents. The preparation of polycarbonates is well known to a skilled person in the art.

Suitable diphenols can be, for example, dihydroxyaryl compounds of the general formula (I)

HO-Z-OH (I)

wherein Z is an aromatic radical having 6 to 34 C atoms, which can contain one or more optionally substituted aromatic nuclei and aliphatic or cycloaliphatic radicals or alkylaryls or hetero atoms as bridge members.

Non limited examples of suitable dihydroxyaryl compounds are: dihydroxybenzenes, dihydroxydiphenyls, bis-(hydroxyphenyl)-alkanes, bis-(hydroxyphenyl)-cycloalkanes, bis-(hydroxyphenyl)-aryls, bis-(hydroxyphenyl) ethers, bis-(hydroxyphenyl) ketones, bis-(hydroxyphenyl) sulfides, bis-(hydroxyphenyl) sulfones, bis-(hydroxyphenyl)-sulfoxides, 1',1'-bis-(hydroxyphenyl)-diisopropylbenzenes, and nucleus-alkylated and nucleus-halogenated compounds thereof.

Preferred dihydroxyaryl compounds are, for example, resorcinol, 4.4'-dihydroxydiphenyl, bis-(4-hydroxyphenyl)-methane, bis-(3,5-dimethyl-4-hydroxyphenyl)-methane, bis-(4-hydroxyphenyl)-diphenyl-methane, 1,1-bis-(4-hydroxyphenyl)-1-phenyl-ethane, 1,1-bis-(4-hydroxyphenyl)-1-(1-naphthyl)-ethane, 1,1-bis-(4-hydroxyphenyl)-1-(2-naphthyl)-ethane, 2,2-bis-(4-hydroxyphenyl)-propane, 2,2-bis-(3-methyl-4-hydroxyphenyl)-propane, 2,2-bis-(3,5-dimethyl-4-hydroxyphenyl)-propane, 2,2-bis-(4-hydroxyphenyl)-1-phenyl-propane, 2,2-bis-(4-hydroxyphenyl)-hexafluoropropane, 2,4-bis-(4-hydroxyphenyl)-2-methyl-butane, 2,4-bis-(3,5-dimethyl-4-hydroxyphenyl)-2-methylbutane, 1,1-bis-(4-hydroxy¬phenyl)-cyclohexane, 1,1-bis-(3,5-dimethyl-4-hydroxyphenyl)-cyclohexane, 1,1-bis-(4-hydroxyphenyl)-4-methyl-cyclohexane, 1,3-bis-[2-(4-hydroxyphenyl)-2-propyl]-benzene, 1,1'-bis-(4-hydroxyphenyl)-3-diisopropyl-benzene, 1,1'-bis-(4-hydroxyphenyl)-4-diisopropyl-benzene, 1,3-bis-[2-(3,5-dimethyl-4-hydroxyphenyl)-2-propyl]-benzene, bis-(4-hydroxyphenyl) ether, bis-(4-hydroxyphenyl) sulfide, bis-(4-hydroxyphenyl) sulfone, bis-(3,5-dimethyl-4-hydroxyphenyl) sulfone and 2,2',3,3'-tetrahydro-3,3,3',3'-tetramethyl-1,1'-spirobi-[1H-indene]-5,5'-diol or
dihydroxydiphenylcycloalkanes of the formula (Ia) 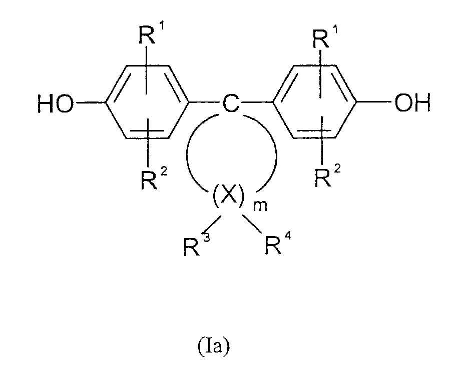 wherein
- R¹ and R²: independently of one another denote hydrogen, halogen, preferably chlorine or bromine, C₁-C₈-alkyl, C₅-C₆-cycloalkyl, C₆-C₁₀-aryl, preferably phenyl, and C₇-C₁₂-aralkyl, preferably phenyl-C₁-C₄-alkyl, in particular benzyl,
- m: denotes an integer from 4 to 7, preferably 4 or 5,
- R³ and R⁴: can be chosen individually for each X and independently of one another denote hydrogen or C₁-C₆-alkyl and
- X: denotes carbon,
with the proviso that on at least one atom X, R³ and R⁴ simultaneously denote alkyl. Preferably, in the formula (Ia) R³ and R⁴ are simultaneously alkyl on one or two atom(s) X, in particular only on one atom X.

The preferred alkyl radical for the radicals R³ and R⁴ in formula (Ia) is methyl. The X atoms in the alpha position to the diphenyl-substituted C atom (C-1) are preferably not dialkyl-substituted, but in contrast alkyl disubstitution in the beta position to C-1 is preferred.

Particularly preferred dihydroxydiphenylcycloalkanes of the formulae (Ia) are those having 5 and 6 ring C atoms X in the cycloaliphatic radical (m = 4 or 5 in formula (Ia)), for example the diphenols of the formulae (Ib) to (Id)

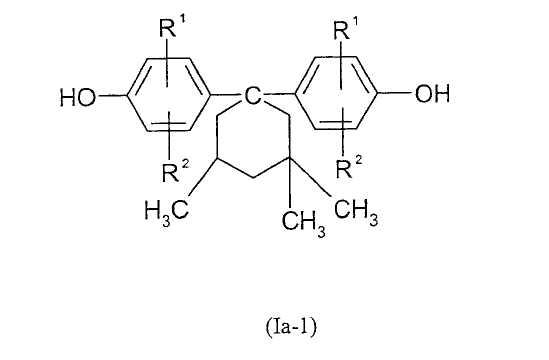

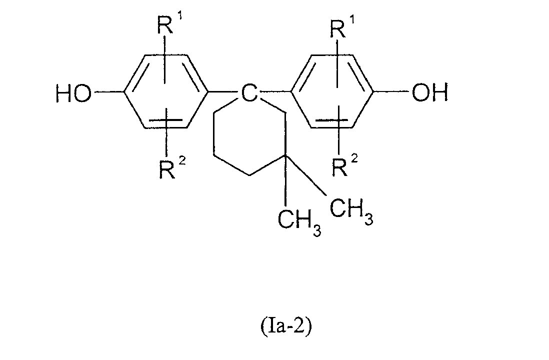

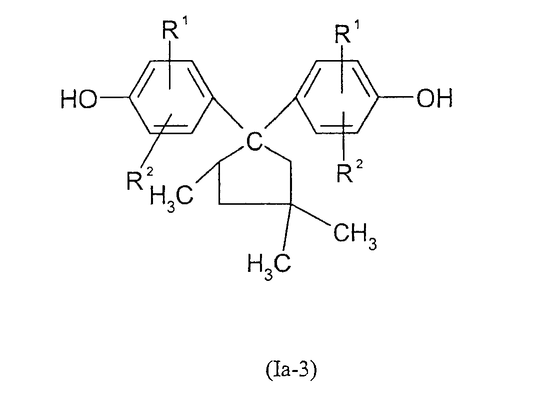

A very particularly preferred dihydroxydiphenylcycloalkane of the formula (Ia) is 1,1-bis-(4-hydroxyphenyl)-3,3,5-trimethyl-cyclohexane (formula (Ia-1) where R¹ and R² are H).

Such polycarbonates can be prepared in accordance with EP-A 359 953 from dihydroxydiphenylcycloalkanes of the formula (Ia).

Particularly preferred dihydroxyaryl compounds are resorcinol, 4,4'-dihydroxydiphenyl, bis-(4-hydroxyphenyl)-diphenyl-methane, 1,1 -bis-(4-hydroxyphenyl)-1-phenyl-ethane, bis-(4-hydroxyphenyl)-1-(1-naphthyl)-ethane, bis-(4-hydroxyphenyl)-1-(2-naphthyl)-ethane, 2,2-bis-(4-hydroxyphenyl)-propane, 2,2-bis-(3,5-dimethyl-4-hydroxyphenyl)-propane, 1,1-bis-(4-hydroxyphenyl)-cyclohexane, 1,1-bis-(3,5-dimetyl-4-hydroxyphenyl)-cyclohexane, 1,1-bis-(4-hydroxyphenyl)-3,3,5-trimethyl-cyclohexane, 1,1'-bis-(4-hydroxyphenyl)-3-diisopropyl-benzene and 1,1'-bis-(4-hydroxyphenyl)-4-diisopropyl-benzene.

Very particularly preferred dihydroxyaryl compounds are 4,4'-dihydroxydiphenyl, 2,2-bis-(4-hydroxyphenyl)-propane and 1,1-bis-(4-hydroxyphenyl)-3,3,5-trimethyl-cyclohexane.

It is possible to use either one dihydroxyaryl compound to form homopolycarbonates or various dihydroxyaryl compounds to form copolycarbonates.

It is possible to use either one dihydroxyaryl compound of the formula (I) or (Ia) to form homopolycarbonates or several dihydroxyaryl compounds of the formula (I) and/or (Ia) to form copolycarbonates. In this context, the various dihydroxyaryl compounds can be linked to one another either randomly or blockwise. In the case of copolycarbonates from dihydroxyaryl compounds of the formula (I) and (Ia), the molar ratio of dihydroxyaryl compounds of the formula (Ia) to the other dihydroxyaryl compounds of the formula (I) optionally to be co-used is preferably between 99 mol% of (Ia) to 1 mol% of (I) and 2 mol% of (Ia) to 98 mol% of (I), preferably between 99 mol% of (Ia) to 1 mol% of (I) and 10 mol% of (Ia) to 90 mol% of (I) and in particular between 99 mol% of (Ia) to 1 mol% of (I) and 30 mol% of (Ia) to 70 mol% of (I).

A very particularly preferred copolycarbonate can be prepared using 1,1-bis-(4-hydroxyphenyl)-3,3,5-trimethyl-cyclohexane and 2,2-bis-(4-hydroxyphenyl)-propane as dihydroxyaryl compounds of the formula (Ia) and (I).

Suitable carbonic acid derivatives can be, for example, diaryl carbonates of the general formula (II) 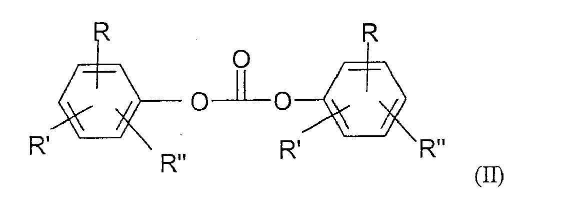 wherein
- R, R' and R": independently of one another are identical or different and represent hydrogen, linear or branched C₁-C₃₄-alkyl, C₇-C₃₄-alkylaryl or C₆-C₃₄-aryl, R furthermore can also denote -COO-R"', wherein R"' represents hydrogen, linear or branched C₁-C₃₄-alkyl, C₇-C₃₄-alkylaryl or C₆-C₃₄-aryl.

Preferred diaryl carbonates are, for example, diphenyl carbonate, methylphenyl phenyl carbonates and di-(methylphenyl) carbonates, 4-ethylphenyl phenyl carbonate, di-(4-ethylphenyl) carbonate, 4-n-propylphenyl phenyl carbonate, di-(4-n-propylphenyl) carbonate, 4-iso-propylphenyl phenyl carbonate, di-(4-iso-propylphenyl) carbonate, 4-n-butylphenyl phenyl carbonate, di-(4-n-butylphenyl) carbonate, 4-iso-butylphenyl phenyl carbonate, di-(4-iso-butylphenyl) carbonate, 4-tert-butylphenyl phenyl carbonate, di-(4-tert-butylphenyl) carbonate, 4-n-pentylphenyl phenyl carbonate, di-(4-n-phenylphenyl) carbonate, 4-n-hexylphenyl phenyl carbonate, di-(4-n-hexylphenyl) carbonate, 4-iso-octylphenyl phenyl carbonate, di-(4-iso-octylphenyl) carbonate, 4-n-nonylphenyl phenyl carbonate, di-(4-n-nonylphenyl) carbonate, 4-cyclohexylphenyl phenyl carbonate, di-(4-cyclohexylphenyl) carbonate, 4-(1-methyl-1-phenylethyl)-phenyl phenyl carbonate, di-[4-(1-methyl-1-phenylethyl)-phenyl] carbonate, biphenyl-4-yl phenyl carbonate, di(biphenyl-4-yl) carbonate, 4-(1-naphthyl)-phenyl phenyl carbonate, 4-(2-naphthyl)-phenyl phenyl carbonate, di-[4-(1-naphthyl)-phenyl] carbonate, di-[4-(2-naphthyl)-phenyl] carbonate, 4-phenoxyphenyl phenyl carbonate, di-(4-phenoxyphenyl) carbonate, 3-pentadecylphenyl phenyl carbonate, di-(3-pentadecylphenyl) carbonate, 4-tritylphenyl phenyl carbonate, di-(4-tritylphenyl) carbonate, methyl-salicylate phenyl carbonate, di-(methyl-salicylate) carbonate, ethyl-salicylate phenyl carbonate, di-(ethyl-salicylate) carbonate, n-propyl-salicylate phenyl carbonate, di-(n-propyl-salicylate) carbonate, iso-propyl-salicylate phenyl carbonate, di-(iso-propyl-salicylate) carbonate, n-butyl-salicylate phenyl carbonate, di-(n-butyl-salicylate) carbonate, iso-butyl-salicylate phenyl carbonate, di-(iso-butyl-salicylate) carbonate, tert-butyl-salicylate phenyl carbonate, di-(tert-butyl-salicylate) carbonate, di-(phenyl-salicylate) carbonate and di-(benzyl-salicylate) carbonate.

Particularly preferred diaryl compounds are diphenyl carbonate, 4-tert-butylphenyl phenyl carbonate, di-(4-tert-butylphenyl) carbonate, diphenyl-4-yl phenyl carbonate, di-(biphenyl-4-yl) carbonate, 4-(1-methyl-1-phenylethyl)-phenyl phenyl carbonate, di-[4-(1-methyl-1-phenylethyl)-phenyl] carbonate and di-(methylsalicylate) carbonate.

Diphenyl carbonate is very particularly preferred.

It is possible to use either one diaryl carbonate or various diaryl carbonates.

To control or modify the end groups, for example, one or more monohydroxyaryl compound(s) which has/have not been used for the preparation of the diaryl carbonate(s) used can additionally be employed as chain terminators. In this context, these can be those of the general formula (III) 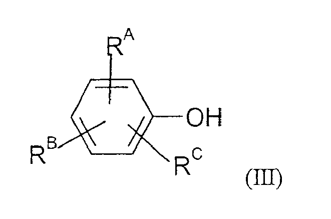 wherein
- R^{A}: represents linear or branched C₁-C₃₄-alkyl, C₇-C₃₄-alkylaryl, C₆-C₃₄-aryl or COO-R^{D}, wherein R^{D} represents hydrogen, linear or branched C₁-C₃₄-alkyl, C₇-C₃₄-alkylaryl or C₆-C₃₄-aryl, and
- R^{B}, R^{C}: independently of one another are identical or different and represent hydrogen, linear or branched C₁-C₃₄-alkyl, C₇-C₃₄-alkylaryl or C₆-C₃₄-aryl.
Such monohydroxyaryl compounds are, for example, 1-, 2- or 3-methylphenol, 2,4-dimethylphenol, 4-ethylphenol, 4-n-propylphenol, 4-iso-propylphenol, 4-n-butylphenol, 4-isobutylphenol, 4-tert-butylphenol, 4-n-pentylphenol, 4-n-hexylphenol, 4-iso-octylphenol, 4-n-nonylphenol, 3-pentadecylphenol, 4-cyclohexylphenol, 4-(1-methyl-1-phenylethyl)-phenol, 4-phenylphenol, 4-phenoxyphenol, 4-(1-naphthyl)-phenol, 4-(2-naphthyl)-phenol, 4-tritylphenol, methyl salicylate, ethyl salicylate, n-propyl salicylate, iso-propyl salicylate n-butyl salicylate, isobutyl salicylate, tert-butyl salicylate, phenyl salicylate and benzyl salicylate.
4-tert-Butylphenol, 4-iso-octylphenol and 3-pentadecylphenol are preferred.

Suitable branching agents can be compounds having three and more functional groups, preferably those having three or more hydroxyl groups.

Suitable compounds having three or more phenolic hydroxyl groups are, for example, phloroglucinol, 4,6-dimethyl-2,4,6-tri-(4-hydroxyphenyl)-hept-2-e n e, 4,6-dimethyl-2,4,6-tri-(4-hydroxyphenyl)-heptane, 1,3,5-tri-(4-hydroxyphenyl)-benzene, 1,1,1-tri-(4-hydroxyphenyl)-ethane, tri-(4-hydroxyphenyl)-phenylmethane, 2,2-bis-(4,4-bis-(4-hydroxyphenyl)-cyclohexyl]-propane, 2,4-bis-(4-hydroxyphenyl-isopropyl)-phenol and tetra-(4-hydroxyphenyl)-methane.

Other suitable compounds having three and more functional groups are, for example, 2,4-dihydroxybenzoic acid, trimesic acid (trichloride), cyanuric acid trichloride and 3,3-bis-(3-methyl-4-hydroxyphenyl)-2-oxo-2,3-dihydroindole.

Preferred branching agents are 3,3-bis-(3-methyl-4-hydroxyphenyl)-2-ox-2,3-dihydroindole and 1,1,1-tri-(4-hydroxyphenyl)-ethane.

Poly- or copolyalkylene terephthalates or poly- or copolyalkylene naphthalates are suitable in preferred embodiments of the invention as poly- or copolycondensates of terephthalic acid or naphthalene dicarboxylic acid. Suitable poly- or copolyalkylene terephthalates or poly- or copolyalkylene naphthalates are for example reaction products of aromatic dicarboxylic acids or reactive derivatives thereof (for example dimethyl esters or anhydrides) and aliphatic, cycloaliphatic or araliphatic diols and mixtures of these reaction products.

Preferred poly- or copolyalkylene terephthalates can be produced by known methods from terephthalic acid (or reactive derivatives thereof) and aliphatic or cycloaliphatic diols having 2 to 10 C atoms (Kunststoff-Handbuch, Vol. VIII, p. 695 ff, Karl-Hanser-Verlag, Munich 1973).

Preferred poly- or copolyalkylene terephthalates or poly- or copolyalkylene naphthalates contain at least 80 mol%, preferably 90 mol% terephthalic acid or naphthalene dicarboxylic acid radicals, relative to the dicarboxylic acid component, and at least 80 mol%, preferably at least 90 mol% ethylene glycol and/or butanediol-1,4 radicals, relative to the diol component.

The preferred poly- or copolyalkylene terephthalates or poly- or copolyalkylene naphthalates can contain in addition to terephthalic acid or naphthalene dicarboxylic acid radicals up to 20 mol% of radicals of other aromatic dicarboxylic acids having 8 to 14 C atoms or aliphatic dicarboxylic acids having 4 to 12 C atoms, such as for example radicals of phthalic acid, isophthalic acid, naphthalene-2,6-dicarboxylic acid (in case of poly- or copolyalkylene terephthalates), terephthalic acid (in case of poly- or copolyalkylene naphthalates), 4,4'-diphenyl dicarboxylic acid, succinic acid, adipic acid, sebacic acid, azelaic acid and/or cyclohexane diacetic acid.

The preferred poly- or copolyalkylene terephthalates or poly- or copolyalkylene naphthalates can contain in addition to ethylene or butanediol-1,4 glycol radicals up to 20 mol% of other aliphatic diols having 3 to 12 C atoms or cycloaliphatic diols having 6 to 21 C atoms, for example radicals of propanediol-1,3, 2-ethylpropanediol-1,3, neopentyl glycol, pentanediol-1,5, hexanediol-1,6, cyclohexane dimethanol-1,4, 3-methylpentanediol-2,4, 2-methylpentanediol-2,4, 2,2,4-trimethylpentanediol-1,3 and 2-ethylhexanediol-1,6, 2,2-diethylpropanediol-1,3, hexanediol-2,5, 1,4-di-([beta]-hydroxyethoxy)-benzene, 2,2-bis-(4-hydroxycyclohexyl)propane, 2,4-dihydroxy-1,1,3,3-tetramethylcyclobutane, 2,2-bis-(3-[beta]-hydroxyethoxyphenyl)propane and 2,2-bis-(4-hydroxypropoxyphenyl)propane (cf. DE-OS 24 07 674, 24 07 776, 27 15 932).

The poly- or copolyalkylene terephthalates or poly- or copolyalkylene naphthalates can be branched by incorporating relatively small amounts of trihydric or tetrahydric alcohols or tribasic or tetrabasic carboxylic acids, as described for example in DE-OS 19 00 270 and US-PS 3 692 744. Examples of preferred branching agents are trimesic acid, trimellitic acid, trimethylol ethane and propane and pentaerythritol.

No more than 1 mol% of the branching agent, relative to the acid component, is preferably used.

Poly- or copolyalkylene terephthalates or poly- or copolyalkylene naphthalates can also be branched in incorporating relatively small amounts of ethylenically unsatured groups into the polymer chain, followed by subsequent crosslinking as described in US 2009-0324922 A1.

Poly- or copolyalkylene terephthalates produced solely from terephthalic acid and reactive derivatives thereof (for example dialkyl esters thereof) and ethylene glycol and/or butanediol-1,4, and mixtures of these polyalkylene terephthalates are particularly preferred.

Poly- or copolyalkylene naphthalates produced solely from naphthalene dicarboxylic acid and reactive derivatives thereof (for example dialkyl esters thereof) and ethylene glycol are particularly preferred.

Preferred poly- or copolyalkylene terephthalates or poly- or copolyalkylene naphthalates are also copolyesters produced from at least two of the aforementioned acid components and/or from at least two of the aforementioned alcohol components, particularly preferred copolyesters being poly(ethylene glycol/butanediol-1,4) terephthalates.

In preferred embodiments, the process steps (a) and (b) of the process according to the invention are passed through several times in succession. The coating steps (a) and (b) are preferably followed once more by at least step (a), so that a multi-layer coating, i.e. an organic layer between two inorganic layers, containing one and a half dyads is applied. In this context, a sequence of an inorganic and an organic layer is referred to as a dyad. It is further preferred for the coating steps (a) and (b) also to be followed at least once more by the steps (a) and (b), which leads to a multi-layer coating with alternate inorganic and organic layers. These embodiments can be achieved either by connecting suitable devices for the vacuum and wet coating in series, so that several dyads of inorganic and organic layers can be applied in a continuous process roll to roll, or by winding up a flexible substrate coated by means of step (a) and (b) and introducing it back into the process according to the invention as a flexible substrate to be coated again, so that only one dyad of an inorganic and an organic layer is applied roll to roll in a continuous process.

Particularly preferably the coated flexible substrate is provided with a release film at least on the coated side before or during winding. This takes place particularly in order to protect the coating from damage and thus from impairment to or loss of function.

Multi-layer constructions of this type allow the oxygen and/or water barrier property of the coated plastics films to be improved preferably by several orders of magnitude. Plastics films coated in this way can preferably be produced with an oxygen permeability of less than 10⁻³ cm³/m²/day, preferably less than 10⁻⁴ cm³/m²/day, particularly preferably less than 10⁻⁵ cm³/m²/day and/or a water permeability of less than 10⁻³ g/m²/day, preferably less than 10⁻⁴ g/m²/day, particularly preferably less than 10⁻⁵ g/m²/day.

According to the invention, at least one gas gate is located between a vacuum coating chamber and an area for the wet coating process, preferably in each case one gas gate, to allow the transition from a pressure of less than 10⁻² bar to atmospheric pressure and vice versa.

The present invention also provides a roll-to-roll coating device for the continuous production of a flexible substrate, preferably a plastics film containing a multi-layer coating, characterised in that the device has
- at least one unwinding device,
- at least one vacuum coating chamber with a pressure of less than 10⁻² bar with at least one vacuum coating module,
- at least one wet coating area at atmospheric pressure with at least one wet coating unit,
- at least one gas gate between a vacuum chamber and a wet coating area,
- one or more air turn roller(s) for the contactless transport of the coated film outside the vacuum chamber, and
- at least one winding device.

By using the air turn rollers, contact of the coated side of the flexible substrate with the transport and/or guide rolls, and resulting damage to the coating, can be avoided completely. In addition, this procedure offers the possibility of producing even fully coated substrates without the risk of damaging the coating by the transport and/or guide rolls, and the width of the substrate, in particular the film web used as substrate for the coating is not restricted unnecessarily by the transport and/or guide rolls.

Additionally, the roll-to-roll coating device according to the present invention can comprise additional conventional transport and/or guide rolls, such as e.g. metal transport and/or guide rolls for transporting the coated flexible substrate where the transport allows that only the uncoated side of the substrate comes into contact with these rolls.

Within the wet coating area there is at least one device for the application of the coating composition. This can be, for example, a device for spraying, casting, knife-coating, printing or a roller coater. It is preferred to use one or more slot dies for casting or at least one roller coater or at least one roll for gravure printing or flexo printing.

Preferrably but not limited for the case that the wet coating process is used under clean-room conditions and/or in a low oxygen or low humidity level environment, the wet coating area is located in an appropriately sealed enclosure. For the case that the wet coating process is used under clean-room conditions and/or in a low oxygen or low humidity level environment clean-room control technology and/or oxygen or humidity level control technology is required.

The term atmospheric pressure within the meaning of the invention is understood to be the ambient pressure prevailing at the location where the process is implemented. Within the meaning of the invention, however, atmospheric pressure can also be a pressure between 0.8 and 1.2 bar, preferably between 0.9 and 1.1 bar.

The device according to the invention preferably contains a drying device, preferably a thermal drying device, within or downstream of the wet coating area. This can be for example an oven, a drying line or drying unit or one or more consecutive blowers. The drying can take place at room temperature or at elevated temperature. It preferably takes place at elevated temperature.

The device according to the invention preferably contains a device for curing the organic coating within or downstream of the wet coating area. Where a drying device is also present, the device for curing is preferably located downstream of this drying device. The device for curing can be a device for thermal curing or for radiation curing and the device for curing is preferably a device for radiation curing. It is particularly preferably a device for curing by means of UV radiation or electron beams, most particularly preferably for curing by means of UV radiation. In preferred embodiments, it can be one or more UV radiators arranged in series and/or in parallel.

It is also possible to perform drying and curing in the same step, e.g. within the same device such as but not limited to a drying line or drying unit comprising infrared (IR) radiators. Additionally, the devices for drying and curing can be arranged in a manner that curing already starts in the drying device or drying is even finished in the curing device.

In the event of drying and/or curing under clean-room conditions and/or in a low oxygen or low humidity level environment, the device(s) for drying and/or curing are preferably integrated into the sealed enclosure for the wet coating process.

In the device according to the invention, a vacuum chamber and a wet coating area preferably follow one another alternately. In the simplest embodiment, the device according to the invention contains one vacuum chamber, which is followed by a wet coating area. In another embodiment of the device according to the invention, this one wet coating area can be followed by a further vacuum chamber, in which case a drying and/or curing device may optionally also be present between the wet coating area and the second vacuum chamber. In further embodiments of the device according to the invention, each vacuum chamber and wet coating area can be followed alternately by at least one further vacuum chamber and wet coating area.

In all embodiments at least one, preferably in each case one, gas gate is located between a vacuum chamber and a wet coating area to allow the transition from a pressure of less than 10⁻² bar to atmospheric pressure and vice versa. Such gas gates are known to the person skilled in the art and are described for example in US 6,878,207 B2.

Additionally, the roll-to-roll coating device according to the present invention comprises one or more, preferably more than one pump(s) to achieve the desired pressure range in the vacuum chamber and the gas gate(s) as well as in the optionally used pressure equalisation area between the vacuum chamber and the gas gate(s).

In preferred embodiments there can also be a pressure equalisation area between the vacuum chamber and the gas gate, e.g. in the form of a chamber or a tunnel, in which the pressure can be decreased continuously from less than 10⁻² bar to a value up to 10⁻⁶ bar, preferably to a value up to 10⁻⁷ bar. The chamber or tunnel is preferably designed to have limited conductance (small cross-section) to limit gas flow. Preferably multiple pumping units are positioned along the chamber or tunnel for differential pumping to form pressures stages that enables continuous pressure change from 10⁻² bar to a value to a value up to 10⁻⁶ bar, preferably to a value up to 10⁻⁷ bar.

In an exemplary and particularly preferred embodiment, the roll-to-roll coating device according to the invention has
- at least two vacuum coating chambers with a pressure of less than 10⁻² bar with at least one vacuum coating module each,
- at least one wet coating area at atmospheric pressure with at least one wet coating unit between these two vacuum coating chambers,
- at least one, preferably in each case one gas gate between a vacuum chamber and the wet coating area.

In the device according to the invention, the wind-off roll for unwinding the flexible substrate to be coated can be located in a vacuum chamber, in which a pressure of less than 10⁻² bar also prevails and which is connected to the first ― optionally the only ― vacuum chamber for the vacuum coating, but can also be sealed off from this. This enables the roll of flexible substrate to be changed without the need for an additional gas gate for a transition from atmospheric pressure to vacuum and without the entire vacuum coating chamber having to be ventilated.

In this vacuum chamber or the first ― optionally the only ― vacuum coating chamber a device can be contained with which the surface of the preferably uncoated flexible substrate fed into the process according to the invention is cleaned and/or pretreated to improve adhesion. Such cleaning and/or pretreatment can be performed with or without direct contact to the flexible substrate. Contact cleaning of the flexible substrate surface for example can be done by using tacky rollers. Contactless cleaning or pretreatment can take place for example by means of plasma pretreatment or ion beam pretreatment. Additionally, contactless and contact cleaning and/or pretreatment can be used in combination.

Furthermore, in the vacuum chamber or the first ― optionally the only ― vacuum-coating chamber a device can be contained with which the preferably uncoated flexible substrate, in particular the uncoated plastics film fed into the process according to the invention is outgassed. Such a device can be for example a heating device, such as e.g. one or more IR radiators.

The flexible substrate fed into the process according to the invention can preferably have a release film which is removed using a demasker before coating and before any surface treatment and/or outgassing.

The flexible substrate coated using the process according to the invention can preferably be provided with a release film with the aid of a remasker, at least on the coated side, before or during winding.

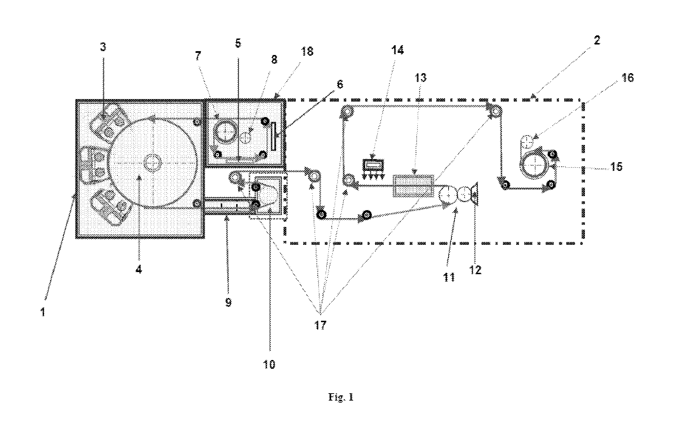

An exemplary and most particularly preferred embodiment of the roll-to-roll coating device according to the invention is shown diagrammatically in Fig. 1. Fig. 1 is intended to explain an example of the invention and should not be interpreted as a restriction.

Fig. 1 shows a device according to the invention containing a vacuum coating chamber (1), a wet coating area (2) and a gas gate (10). In the vacuum coating chamber (1) there are three vacuum coating modules (3) and a central metal drum (4) by means of which the plastics film to be coated is guided past the vacuum coating modules (3). The central metal drum (4) preferably contains a cooling system inside the drum to cool the plastics film during coating. The plastics film to be coated is introduced from an outer chamber (18), which is a vacuum chamber that can be connected to the vacuum coating chamber (1) or sealed off from this, into the vacuum coating chamber (1). In the outer chamber (18) there is an unwinding device (7), into which the roll of film is inserted, a demasker (8) for the simultaneous removal of the release film while unwinding the plastics film, and one or more IR lamps (5) for outgassing the plastics film and a device (6) for the plasma or ion beam treatment of the surface of the plastics film to be coated. After unwinding and removing the release film, the plastics film to be coated is guided past the IR lamp or lamps (5) and the device (6) for the plasma or ion beam treatment in succession.

Between the vacuum coating chamber (1) and the gas gate (10) there is a pressure equalisation tunnel (9).

Inside the wet coating area (2) there is a wet coater (11) with a slot die (12), by means of which the organic layer is applied on to the inorganic coating, as well as a thermal drying device (13), one or more UV lamps (14), several air turn rollers (17), a winding device (15) and a remasker (16). After exiting the gas gate (10), the plastics film coated with the inorganic layer is passed via an air turn roller (17) and conventional guide and/or transport rolls (not numbered) to the wet coater (11) and then through a thermal drying device (13). Then, the plastics film is fed past one or more UV lamps (14) with its coated side facing them, and transported via air turn rollers (17) and conventional guide and/or transport rolls (not numbered) to the winding device (15), where a release film is applied on the coated side by the remasker (16) in parallel to the winding operation.

The non-numbered guide and/or transport rolls in Fig. 1 are conventional metal guide and/or transport rolls. The coated film only has contact with these on its uncoated reverse side. Everywhere that transport of the coated plastics film has to take place such that the coated side of the plastics film faces the guide and/or transport roll, the transport takes place via the air turn rollers (17).

The present invention also provides a coated flexible substrate, preferably a coated plastics film obtainable with the process according to the present invention. Preferably such a coated flexible substrate, preferably a coated plastics film comprises a barrier coating, transparent conductive coating or anti-reflection coating.

## Claims

1. A process for the continuous production of a flexible substrate, preferably a plastics film containing a multi-layer coating in a roll-to-roll coating process, wherein the multi-layer coating has at least one inorganic and at least one organic layer, **characterised in that**
(a) at least one inorganic layer of the multi-layer coating is applied in at least one vacuum coating chamber at a pressure of less than 10⁻² bar with a vacuum coating process, and
(b) at least one organic layer of the multi-layer coating is applied at atmospheric pressure in a wet coating process,
wherein at least one gas gate is located between a vacuum coating chamber and an area for the wet coating process and
the transport of the coated flexible substrate outside the vacuum coating chamber takes place in such a way that the side of the flexible substrate having the coating has no direct contact with the transport and/or guide rolls.

2. The process according to claim 1, **characterised in that** the pressure in the vacuum coating chamber is 10⁻³ to 10⁻⁷ bar.

3. The process according to claim 1 or 2, **characterised in that** the inorganic layer contains at least one oxide, nitride, carbide, boride, fluoride or mixtures of these.

4. The process according to at least one of claims 1 to 3, **characterised in that** the vacuum coating process is a chemical or physical vapour deposition, a reactive sputtering process or a reactive evaporation process.

5. The process according to at least one of claims 1 to 4, **characterised in that** the wet coating process is a spray process, casting process, knife-coating process, printing process, roller coating or other wet coating process.

6. The process according to at least one of claims 1 to 5, **characterised in that** the organic layer is optionally dried, preferably thermally dried, and the optionally dried organic layer is cured, preferably radiation-cured, after application.

7. The process according to at least one of claims 1 to 6, **characterised in that** the coating composition for the organic layer contains ethylenically unsaturated compounds.

8. The process according to at least one of claims 1 to 7, **characterised in that** inorganic and organic layers alternate in the multi-layer coating and the coating steps (a) and (b) are followed once more by at least step (a), preferably at least once more by steps (a) and (b).

9. The process according to at least one of claims 1 to 8, **characterised in that** the multi-layer coating is a barrier coating.

10. A roll-to-roll coating device for the continuous production of a flexible substrate, preferably a plastics film containing a multi-layer coating, **characterised in that** the device has
- at least one unwinding device,
- at least one vacuum coating chamber with a pressure of less than 10⁻² bar with at least one vacuum coating module,
- at least one wet coating area at atmospheric pressure with at least one wet coating unit,
- at least one gas gate between a vacuum chamber and a wet coating area,
- one or more air turn roller(s) for the contactless transport of the coated flexible substrate outside the vacuum chamber, and
- at least one winding device.

11. The roll-to-roll coating device according to claim 10, **characterised in that** this has a drying device, preferably a thermal drying device, within or downstream of the wet coating area.

12. The roll-to-roll coating device according to claim 10 or 11, **characterised in that** this has a device for curing the organic coating, preferably a UV irradiation device, within or downstream of the wet coating area.

13. The roll-to-roll coating device according to at least one of claims 10 to 12, **characterised in that** a vacuum chamber and a wet coating area follow one another alternately in each case.

14. The roll-to-roll coating device according to at least one of claims 10 to 13, **characterised in that** a gas gate is located between a vacuum chamber and a wet coating area in each case.

15. The roll-to-roll coating device according to at least one of claims 10 to 14, **characterised in that** it has
- at least two vacuum coating chambers with a pressure of less than 10⁻² bar with at least one vacuum coating module each,
- at least one wet coating area at atmospheric pressure with at least one wet coating unit between these two vacuum coating chambers,
- at least one, preferably in each case one, gas gate between a vacuum chamber and the wet coating area.
